# EUROPEAN PATENT APPLICATION

(11) **EP 1 501 126 A1**
(43) Date of publication of application: **26.01.2005**
(21) Application number: 03025460.1
(22) Date of filing: 05.11.2003
(51) Int. Cl.: H01L 25/065

(54) **Semiconductor chip having a cavity for stacked die application**

(71) Applicant: Infineon Technologies AG, 81669 München (DE)
(72) Inventor: Lian, Jenny Ong Wai, 751468 Singapore (SG)
(74) Representative: Schäfer, Horst, Dr.

(57) **Abstract**

A stacked die semiconductor package and a method for manufacturing thereof. The semiconductor package comprises a substrate (1), a bottom semiconductor chip (3) having a cavity (6) on its backside (5) and a top semiconductor chip (9). The bottom semiconductor chip (3) is mounted onto the substrate (1) with its backside (5) and the cavity (6) facing away from the substrate (1), and the top semiconductor chip (9) is mounted into the cavity (6) on the backside (5) of the semiconductor chip (3).

## Description

This invention relates to a stacked semiconductor chip and a method for manufacturing a stacked semiconductor chip.

Semiconductor chips or integrated circuit (IC) dice are small, generally rectangular IC devices cut from a semiconductor wafer, such as a silicon wafer, on which multiple IC's have been fabricated.

One concept to manufacture a semiconductor device is to build a stacked die package starting with a substrate onto which a flip chip is mounted using existing flip chip technology. A second chip is attached onto the flip chip and connected with the substrate. Inventions using this approach have been disclosed in several publications e.g. US 5,973,403 A, TW 479337 A or TW 444364 A.

An alternative approach is to reverse the order of the two chips, meaning to use a conventionally attached chip as bottom chip onto which a top chip is mounted using flip chip technology, as disclosed in TW 480694-A.

Both approaches lead to packages which are not suitable for all stacked die applications.

The object of the present invention is to resolve the aforementioned problem. This object is solved by the subject matter of the independent claims. Further improvements arise from the respective dependent claims.

The present invention provides a new approach to further reduce the package height of a stacked die semiconductor package without having the above mentioned disadvantages.

In addition, the present invention provides means to prevent contamination of the bottom chip stemming from spilled over die attach material of the second semiconductor chip.

The invention relates to a semiconductor chip which comprises a cavity on its backside to be used as the bottom chip in a stacked die package. The cavity is meant to receive a top chip, thus providing means for a chip-in-chip stack assembly with reduced stack height.

The shape of the bottom chip is not altered significantly by the cavity and it is possible and in fact desirable to use standard package assembly processes and equipment and standard or only minimally modified manufacturing tools for the manufacturing of the stacked die packed according to this invention. This is an advantage, as the assembly of a stacked die semiconductor package according to the present invention can be carried out in a standard production environment.

Introducing a cavity into the backside of the bottom chip and then mounting the top chip inside this cavity is an advantageous way of reducing the total stack height and therefore package height, as both the wafer containing the cavity chips and the singulated cavity chip itself are hardly reduced in their structural strength compared to a wafer or a chip without cavity, thus remaining robust enough to be used in a standard production environment.

The alternative, namely thinning of the whole wafer, is not desirable, as wafers, which are thinner then what is usually handled in a standard production environment tend to break easier, thus resulting in a lower yield rate.

Thinning of the top chip however remains an option according to the present invention. If required, the thinning can be kept at a minimum, thereby reducing the problems stemming for the handling of thin wafers or chips to a minimum.

Another advantage of the present invention is that for a given external package height the reduced internal chip stack height introduces more flexibility concerning the internal configuration of the package, e.g. it allows for thicker memory chips to be used as top chips or to introduce a two-tier wire loop profile.

A further advantage of the present invention is that it not only provides means to reduce the package height but also means to reliably control the die attach material bleed out of the top chip and therefore avoids contamination of the bottom chip through material spill over. The cavity in the backside of the bottom chip does not only act as a receptacle for the top chip, but is at the same time receptacle for the die attach material, thus confining the bleed out to the area within the cavity.

An embodiment according to the present invention comprises two semiconductor chips, with the bottom chip being a flip chip, as a flip chip offers an empty backside which provides the largest possible area to include a cavity to receive a top chip, thus having the least restrictions concerning the maximum size or footprint of the top chip.

In this embodiment, the cavities at the backside of the flip chip are manufactured using plasma etching. For this, the whole wafer is mounted onto a mounting tape with its backside facing up. An etching mask is placed above the wafer and the plasma etching process is carried out. After the plasma etching process, the wafer is de-taped and mounted onto a second mounting tape with its topside facing up, before singulating the individual semiconductor chips using a dicing blade.

Another embodiment may comprise a conventionally mounted semiconductor chip as bottom chip directly attached to the substrate. The bottom semiconductor chip has an active surface which comprises besides the electronic structures and contact areas for electrical connections the cavity to receive the second semiconductor chip. This embodiment might be of advantage if the bottom chip comprises only a small number of electrical contacts.

Other embodiments, where a flip chip is used as top chip are possible and might be of advantage if extremely short chip-to-chip connections are required, e.g. for high-frequency applications.

All embodiments have in common that the bottom chip has one side that is facing a substrate and which is used to mount the bottom chip onto said substrate and a top side, which is either complete or partially free and which comprises the cavity used for the mounting of the top chip.

The substrate can comprise different materials, such as ceramic or organic materials or metals such as copper. The choice of substrate material depends on the target application of the stacked semiconductor device. E.g. PGA-packages (pin grid array packages) comprise ceramic substrates, flip chip packages comprise organic based substrates with conductive areas, and packages for power devices or diodes comprise metallic substrates. The actual composition of substrate is of no relevance for the present invention. It is an advantage of this invention that it can be used for all packages which require stacking of dice without being limited by the substrate material.

For further embodiments, e.g. highly specialized package designs, the present invention can be applied to stacked die packages containing multiple chips.

Bare semiconductor chips are packaged to protect them from corrosion by enclosing them in die packages. Such packages work well to protect IC dice. Advantage of the present invention is that the resulting package will be less bulky, which is desirable for many multi-chip applications requiring compact die packaging.

Accordingly, a variety of compact die packaging techniques can be developed. The invention permits stacked packaging of two or more dice within the same package.

The invention also permits reversing the order of flip chip and conventionally attached chip in the package. The total package height can then be reduced compared to the height of a package where a conventional chip with conventional wire bonds is mounted on top of a flip chip, as no additional height on top of the top chip is required to electrically connect the top chip.

Another advantage of the present invention is that it allows the production of highly compact, stacked die packages reliably with high volume in a standard production environment as the wire bond loop height and the thickness of both chips are not changed. Significantly reducing any of these heights would mean the introduction of a non-standard manufacturing step into the production environment. Any deviation from the established manufacturing techniques bears the risk of resulting in an unstable production environment, meaning low productivity, low yield numbers and therefore high costs of the manufactured semiconductor package. Using techniques other then the well established ones is therefore not desirable.

In addition, the present invention addresses another problem that is closely related to providing means for a densely packed semiconductor package, namely the so called bleed out or spillage of the die attach material around the top die. The cavity of the bottom die must provides means to contain the die attach material of the top die, therefore preventing the die attach material of the top chip from spilling over its allocated space and therefore eliminating a source for reduced package reliability.

Another advantage of using the cavity to control the die attach material spillage is that the top die size depends only on the cavity size and therefore can be nearly as large as the bottom chip, if required by the package type.

The invention will now be described by way of example with reference to the drawings.
- Figure 1: shows a cross-sectional view of a stacked die package in an embodiment of the invention,
- Figure 2: shows a cross-sectional view of a part of a flip chip wafer comprising the cavities.

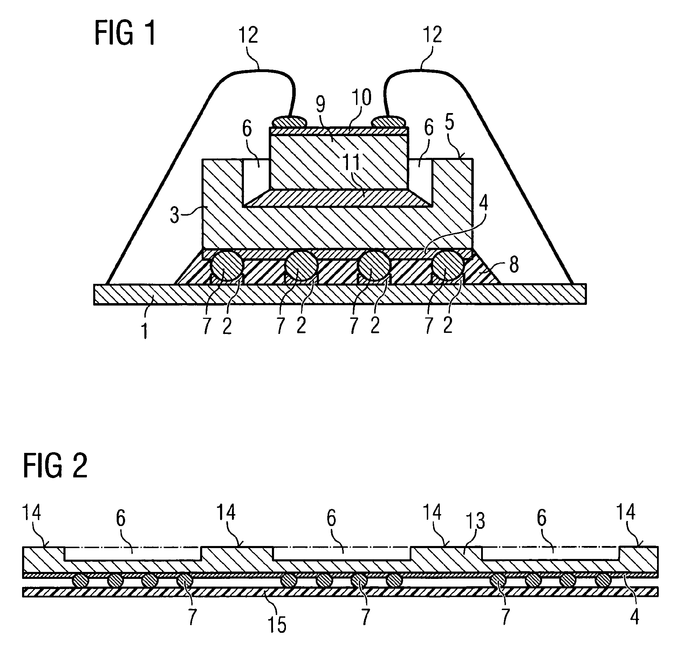

Figure 1 shows the enlarged schematic cross-sectional view of a stacked die package in an embodiment of the present invention. The drawing is not according to scale as to better show the relevant characteristics.

On a substrate 1 a flip chip 3 is mounted. The top of the flip chip 3, comprising a passivation layer 4 and contact pads (not shown), is facing the substrate 1, which comprises further contact pads 2. The electrical connection between substrate 1 and flip chip 3 is formed through flip chip bumps 7. The flip chip bumps 7 are connecting the contact pads 2 on the substrate 1 with the corresponding contact pads (not shown) of the flip chip 3. The gap between the flip chip 3, respectively the passivation layer 4, and the substrate 1 is filled by a plastic material 8, thus enclosing the flip chip bumps 7 completely.

At the backside 5 of the flip chip 3, a cavity 6 is located. In this embodiment of the invention, the cavity 6 partially encloses a top chip 9 and a second die attach layer 11.

The backside of the top chip 9 is connected with the bottom of the cavity 6 of the flip chip 3 by a die attach layer 11. The top surface of the top chip 9, which comprises a passivation layer 10 and contact pads (not shown) is electrically connected to the substrate 1 by wire bonds 12 between contact pads (not shown) on the top surface of the top chip 9 and contact pads (not shown) on the substrate 1.

In an alternative embodiment of the present invention, which is not shown here, the cavity 6 may enclose the top chip 9 and its die attach layer 11 completely.

Further embodiments derived from alternative ways of electrically connecting the top chip 9 are possible but are not discussed here as they are of no relevance to the present invention. This invention seeks to provide a stacked die package based on a bottom chip comprising a recess or cavity 6 to partially or fully enclose a top chip 2, thus resulting in a reduced chip stack and therefore total package height. Package height reduction through alternative means of electrically connecting either of the two chips is not part of the present invention.

Figure 2 shows a cross-sectional view of a part of a flip chip wafer 13 comprising the cavities 6 according to the present invention before the singulation process. The drawing is enlarged and not according to scale as to better show the relevant characteristics.

The wafer 13 has a backside 14, which comprises cavities 6 according to this invention. The front side of the wafer 13 comprises the flip chip bumps 7 and the passivation layer 4. The wafer 13 is connected with a mounting tape 15 via the flip chip bumps 7.

The manufacturing of the cavities 6 is an additional process step which is carried out in this embodiment before the singulation of the individual chips using a plasma etching process. Other embodiments using alternative methods to manufacture these cavities 6 are possible but are not further discussed here as the means of manufacturing the cavities 6 are of no relevance to the present invention.

A stacked die semiconductor package according to the present invention can be assembled as described in the following: A substrate 1, a bottom semiconductor chip 3 having a cavity 6 located on its backside 5 a top semiconductor chip 9 are provided. In a first assembly step the bottom semiconductor chip 3 is mounted with its front side onto the substrate 1. After that, electrical connections 7 between the bottom semiconductor chip 3 and the substrate 1 are provided.

According to the present invention, the bottom semiconductor chip 3 comprises a cavity 6 on its backside 5, which is meant to receive the top semiconductor chip 9 and which faces away from the substrate 1. The top semiconductor chip 9 is mounted into this cavity 6 and electrical connections 12 are provided between the top semiconductor chip 9 and the substrate 1 afterwards.

After the die attach and electrical connecting of bottom semiconductor chip 3 and top semiconductor chip 9, the stacked chips and the substrate 1 are encapsulated and, depending on the type of substrate used, the individual semiconductor packages are singulated.

In an embodiment of the present invention, the bottom semiconductor chip 3 is mounted onto the substrate 1 using flip chip technology.

The mounting of a flip chip with a cavity 6 on its backside 5 according to the present invention requires no special tools for the handling of the flip chip, as tools that were formerly meant to handle the flip chip by its backside 5 are now chosen slightly smaller in size to fit into the cavity 6.

The die attach of the top semiconductor chip 9 into the cavity 6 on the backside 5 of the bottom flip chip 3 and the wire bonding to connect the top semiconductor chip 9 with the substrate 1 is carried out using standard equipment, tools and processes.

## Claims

1. A stacked die semiconductor package comprising the following:
- a substrate (1),
- a bottom semiconductor chip (3) being mounted onto the substrate (1) and having a cavity (6) located at its backside (5),
- electrical connections (7) between the bottom semiconductor chip (3) and the substrate (1),
- a top semiconductor chip (9) being attached into the backside cavity (6) of the bottom semiconductor chip (3),
- electrical connections (12) between the top semiconductor chip (9) and the substrate (1),
- encapsulating material surrounding the stacked bottom semiconductor chip (3) and top semiconductor chip (9), and the substrate (1).

2. A stacked die semiconductor package according to claim 1,
**characterized in that**
the bottom semiconductor chip (3) comprises contact pads and solder bumps (7) connecting said contact pads with the substrate (1) and/or a plastic material (8) surrounding the solder bumps (7) and filling the gap between the substrate (1) and the bottom semiconductor chip (3).

3. A stacked semiconductor package according to claim 1 or claim 2,
**characterized in that**
the electrical connections (12) comprise wire bonds.

4. A semiconductor chip (3) comprising the following features:
- an active side with electronic structures and/or with electrical connections (7),
- a backside (5) comprising a cavity (6).

5. A semiconductor chip comprising an active side with electronic structures, with contact areas for electrical connections, and with a cavity (6).

6. A method to assemble a stacked die semiconductor package, the method comprising the following steps:
- providing a substrate (1),
- providing a bottom semiconductor chip (3) having a cavity (6) located at its backside (5),
- providing a top semiconductor chip (9),
- attaching the bottom semiconductor chip (3) with its front side onto the substrate (1),
- providing electrical connections (7) between the bottom semiconductor chip (3) and the substrate (1),
- attaching the top semiconductor chip (9) into the cavity (6) on the backside (5) of bottom the semiconductor chip (3),
- providing electrical connections (12) between the top semiconductor chip (9) and the substrate (1),
- encapsulating the stacked bottom semiconductor chip (3), the top semiconductor chip (9), and the substrate (1).

7. A method according to claim 5,
**characterized in that**
the bottom semiconductor chip (3) is mounted onto the substrate (1) using flip chip technology.
